**Europäisches Patentamt**

**European Patent Office**

**Office européen des brevets**

(11) Veröffentlichungsnummer: **0 005 883**
**B1**

(19)

(12) # EUROPÄISCHE PATENTSCHRIFT

(45) Veröffentlichungstag der Patentschrift:
**20.01.82**

(21) Anmeldenummer: **79200258.6**

(22) Anmeldetag: **25.05.79**

(51) Int. Cl.³: **H 01 L 49/02,** H 05 K 3/34,
B 23 K 1/08

(54) **Verfahren und Vorrichtung zum Anlöten von Bauteilen an ein Dickschichtsubstrat.**

(30) Priorität: **29.05.78 NL 7805800**

(43) Veröffentlichungstag der Anmeldung:
**12.12.79 Patentblatt 79/25**

(45) Bekanntmachung des Hinweises auf die Patenterteilung:
**20.01.82 Patentblatt 82/3**

(84) Benannte Vertragsstaaten:
**AT BE DE FR GB IT NL**

(56) Entgegenhaltungen:
**US-A-2 869 497**
**US-A-3 217 959**
**US-A-3 765 591**
**US-A-3 778 883**

(73) Patentinhaber: **N.V. Philips' Gloeilampenfabrieken, Pieter Zeemanstraat 6, NL-5621 CT Eindhoven (NL)**

(72) Erfinder: **Van Der Put, Henricus Cornelis Adrianus, P/A Int. Octrooibureau B.V. Prof. Holstlaan 6, NL-5656 AA Eindhoven (NL)**

(74) Vertreter: **Hartung, Erwin Edgar et al, INTERNATIONAAL OCTROOIBUREAU B.V. Prof. Holstlaan 6, NL-5656 AA Eindhoven (NL)**

Verfahren und Vorrichtung zum Anlöten von Bauteilen
an ein Dickschichtsubstrat

Die Erfindung bezieht sich auf ein Verfahren zum Anlöten von Bauteilen an ein Dickschichtsubstrat, das örtlich mit einer Schicht aus Lötpaste versehen ist, auf der die Bauteile ruhen, wobei das Substrat in einer Vorheizphase auf eine Temperatur unterhalb des Schmelzpunktes des Lotes in der Lötpaste vorgeheizt wird, daraufhin in einer Lötphase derart erhitzt wird, dass das Lot geschmolzen und verflüssigt wird und schliesslich in einer Kühlphase auf eine Temperatur unterhalb des Schmelzpunktes des Lotes abgekühlt wird.

Zum Verlöten von Bauteilen mit Dickschichtsubstraten nach der sogenannten Wiederaufschmelzmethode, wobei die Substrate meistens aus keramischem Material, beispielsweise Aluminiumoxid bestehen, ist es allgemein bekannt, die zum Schmelzen des Lotes erforderliche Wärme mittels heisser Luft, durch Strahlungswärme, beispielsweise IR-Strahlung oder durch Kontakt mit einem metallenen Heizblock zuzuführen. Wärmezufuhr mittels heisser Luft oder durch Strahlungswärme erfordert relativ lange Aufwärmezeiten mit der Gefahr einer übermässigen Erwärmung der Bauteile. Wärmezufuhr mit Hilfe eines Heizblockes ergibt, im Hinblick auf die unvermeidlichen Unebenheiten des Substrates und des beim Gebrauch auftretenden Verziehens des Heizblockes, einen ungleichmässigen Wärmestrom durch das Substrat hindurch mit der Notwendigkeit einer Überdosierung der Wärmezufuhr, die wieder zur Überhitzung der Bauteile führen kann.

Die Nachteile dieser herkömmlichen Heizmethoden werden bei einem aus der deutschen Offenlegungsschrift 2 335 467 bekannten Verfahren der eingangs erwähnten Art dadurch vermieden, dass das Substrat während einer vorbestimmten Zeit und ohne Benetzung der bestückten Seite auf einer Welle flüssigen Metalls zum Schwimmen gebracht wird; das Substrat kann mittels IR-Strahler vorgeheizt werden und kühlt unmittelbar nach dem Verlassen der Metallwelle wieder auf Umgebungstemperatur ab; dabei besteht die Gefahr, dass die Bauteile während des relativ langsam verlaufenden Kühlprozesses durch die im Substrat gespeicherte Wärme dennoch überhitzt werden.

Die Erfindung bezweckt nun, ein Verfahren zu schaffen, das es ermöglicht, Bauteile auf zuverlässige und reproduzierbare Weise mit einem Dickschichtsubstrat zu verlöten, ohne Benetzung der bestückten Seite und ohne Gefahr vor Beschädigung der Bauteile und des Substrates und wobei die Zykluszeit im Vergleich zu der des bekannten Verfahrens wesentlich kürzer ist.

Dies wird nach der Erfindung im wesentlichen dadurch erreicht, dass das Substrat in jeder der drei Phasen mit erhitztem flüssigem Metall in Berührung gebracht wird, das als Wärmeübertragungsmedium wirksam ist; wobei das Substrat in der Kühlphase gegenüber den bisherigen Verfahren beschleunigt gekühlt wird.

Dadurch, dass in allen drei Phasen flüssiges Metall einer geeigneten Temperatur als Wärmeübertragungsmedium verwendet wird, wird auch beim Vorheizen und Abkühlen eine relativ hohe und gleichmässige Wärmeübertragung erhalten, dies zusammen mit einer relativ kurzen Behandlungszeit. Die Wärmezufuhr zum Substrat sowie die Wärmeabfuhr vom Substrat ist dosierbar und regelbar. Durch die relativ kurze Behandlungszeit und insbesondere durch die beschleunigte Kühlung wird eine thermische Beschädigung der Bauteile vermieden.

Bei einer bevorzugten Ausführungsform des erfindungsgemässen Verfahrens wird das Substrat nacheinander an einer Anzahl stehender Wellen flüssigen Metalls entlang geführt und gegen dieselben angedrückt.

Dadurch, dass das flüssige Metall in Bewegung gehalten und das Substrat jeweils gegen die Welle flüssigen Metalls gedrückt wird, wird ein intensiver Kontakt des flüssigen Metalls mit dem Substrat erhalten und die Wärmeübertragung gefördert.

Dadurch, dass bei einer weiteren bevorzugten Ausführungsform des erfindungsgemässen Verfahrens das Substrat in der Vorheizphase in zwei Schritten vorgeheizt wird, wird vermieden, dass das Flussmittel in der Lötpaste zu schnell verdampft, was eine Spritzwirkung der im Siebdruckverfahren aufgebrachten Lötpaste herbeiführen könnte. Ausserdem hat es sich herausgestellt, dass das Lot durch die allmähliche Vorheizung völlig schmilzt und gut verfliesst, so dass keine Lotkugeln im Flussmittel zurückbleiben, wodurch die Zuverlässigkeit und die Stärke der schlussendlichen Lötverbindungen erhöht wird.

Eine andere bevorzugte Ausführungsform des erfindungsgemässen Verfahrens, wobei ein Substrat aus Aluminiumoxid mit Lötpaste versehen ist, die aus einer Blei-Zinn-Legierung mit einem Schmelzpunkt von 183°C besteht, weist das Kennzeichen auf, dass in der Vorheizphase sowie in der Lötphase und der Kühlphase als flüssiges Metall jeweils eine Blei-Zinn-Wismut-Legierung mit einem Schmelzpunkt zwischen 95 und 110°C und mit einer Temperatur von 180 ± 5°C, 250 ± 3°C bzw. 110 ± 5°C verwendet wird, wobei das Substrat in der Vorheizphase während 8 Sekunden, in der Lötphase während 2 Sekunden und in der Kühlphase während 2 Sekunden mit dem flüssigen Metall in Berührung gebracht wird.

Versuche haben gezeigt, dass beim Durchführen des Verfahrens mit den gekennzeichneten Parametern optimale Ergebnisse erhalten werden. Lötpasten unterschiedlicher Zusammenstellung flossen gleich gut zusammen; dank der relativ langen Vorheizphase genügt eine relativ kurze Lötphase; in der Kühlphase wird das Substrat innerhalb 2 Sekunden auf wirksame und schnelle Weise bis unter 150°C abgekühlt, und zwar derart, dass die kritische Temperatur der Bauteile, bei der im allgemeinen thermische Beschädigung derselben erfolgt, nicht überschritten wird.

Dickschichtsubstrate mit Bauteilen, die mit Hilfe des erfindungsgemässen Verfahrens verlötet wurden, kennzeichnen sich durch gleichmässige und starke Lötverbindungen mit einer minimalen Zugkraft von 10 N in Richtung senkrecht zu den Substraten.

Die Erfindung bezieht sich ebenfalls auf eine Vorrichtung zum Durchführen des Verfahrens mit einer Vorheizeinheit, einer Löteinheit und einer Kühleinheit, sowie mit Fördermitteln zum kontinuierlichen Transport von Substraten mit damit zu verlötenden Bauteilen an den genannten Einheiten entlang, wobei die Löteinheit einen Wellengenerator zum Erzeugen einer stehenden Welle heissen flüssigen Metalles aufweist, diese Vorrichtung weist nach der Erfindung das Kennzeichen auf, dass die Vorheizeinheit und die Kühleinheit ebenfalls als Wellengeneratoren ausgebildet sind.

Mit der gekennzeichneten Vorrichtung kann eine Reihe von Substraten mit den zu verlötenden Bauteilen aufeinanderfolgend mit konstanter Geschwindigkeit und in einer ununterbrochenen Bewegung an den aufeinanderfolgenden Wellengeneratoren entlang geführt werden; die zum Durchführen des Lötvorganges erforderliche Gesamtzykluszeit liegt in der Grössenordnung von 15 Sekunden bei einer Vorschubgeschwindigkeit von etwa 3 cm/Sekunde.

Bei einer bevorzugten Ausführungsform der erfindungsgemässen Vorrichtung weist die Vorheizeinheit zwei Wellengeneratoren auf. Durch diese einfache Massnahme kann, ohne Änderung der Fördergeschwindigkeit und ohne Stillstand eine relativ lange Vorheizphase verwirklicht werden.

Ein guter Kontakt des Wärmeübertragungsmediums mit den zu behandelnden Substraten wird dadurch gewährleistet, dass bei einer weiteren bevorzugten Ausführungsform der erfindungsgemässen Vorrichtung die Fördermittel mit Führungs- und Klemmelementen versehen sind zum Festhalten der Substrate in Richtung quer zur Förderrichtung. Mit Hilfe der Führungs- und Klemmelemente werden die Substrate jeweils gegen die Metallwellen gedrückt. Dadurch wird vermieden, dass die Substrate durch die Metallwelle in einer Richtung quer zur Förderrichtung angehoben werden und auf der Metallwelle schwimmen, mit der Folge eines weniger intensiven Kontaktes und einer schlechteren Wärmeübertragung.

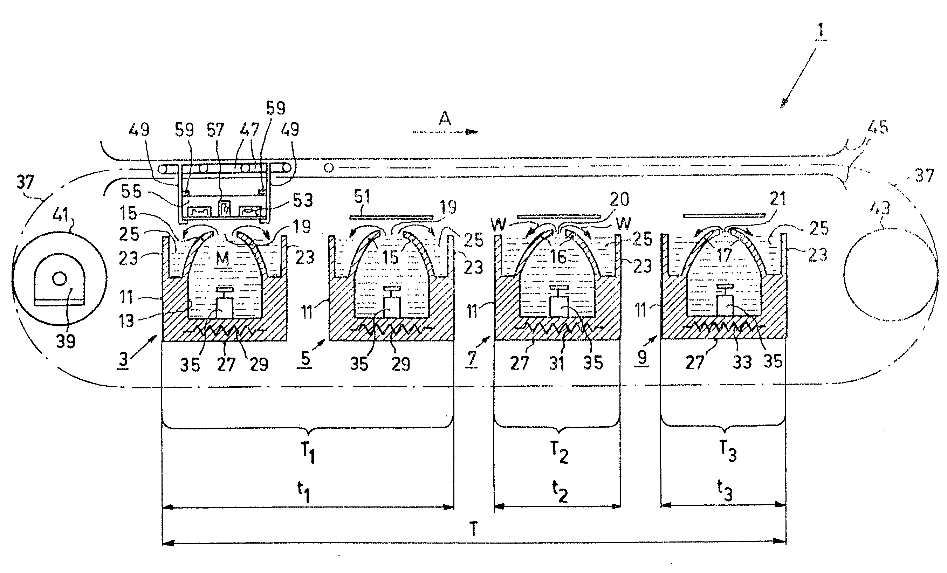

Ein Ausführungsbeispiel der Erfindung ist in der Zeichnung dargestellt und wird im folgenden näher beschrieben.

Die Vorrichtung 1 weist 4 Wellengeneratoren 3, 5, 7 und 9 auf, die fluchtend angeordnet sind. Die Wellengeneratoren sind einer an sich bekannten Konstruktion und bestehen aus je einem Behälter 11 mit einer Kammer 13, die ein Bad heissen flüssigen Metalls M enthält.

Die Kammer 13 ist durch zueinander gerichtete Führungswände 15 bzw. 16 und 17, die eine Ausströmöffnung 19 bzw. 20 und 21 begrenzen, teilweise abgeschlossen. Zwischen den Führungswänden 15, 16 bzw. 17 und stehenden Seitenwänden 23 der Behälter befinden sich Sammelkammern 25, die über nicht dargestellte Rückführungsleitungen mit der Kammer 13 in Verbindung stehen. Im dickwandigen Boden 27 der Behälter sind regelbare elektrische Widerstandselemente 29, 31 33 vorgesehen, die für die Erhitzung des flüssigen Metalles auf die gewünschte Temperatur dienen. In jedem Behälter befindet sich eine Pumpe 35 zum Erzeugen eines Stromes flüssigen Metalls, das durch die Pumpe durch die Ausströmöffnungen 19, 20 bzw. 21 gefördert wird, in Form einer doppelten stehenden Welle W, die über die Führungswände 15, 16 bzw. 17 strömt und in die Sammelkammern 25 zurückfällt, von wo aus das Metall über eine nicht dargestellte Rückführleitung zur Kammer 11 zurückströmt.

Eine zu weitgehende Oxydation des heissen flüssigen Metalls wird auf an sich bekannte Weise durch eine dosierte Zufuhr eines Abdecköls auf dem Metall vermieden.

Die Vorrichtung weist weiter Fördermittel auf, in dem dargestellten Ausführungsbeispiel eine endlose Förderkette 37, die in Richtung des Pfeiles A in einer geschlossenen Umlaufbahn in einem gewissen Abstand an den Ausströmöffnungen der Wellengeneratoren entlang geführt wird. Die Förderkette wird von einem drehzahlgeregelten Elektromotor 39 über ein Kettenrad 41 angetrieben. Längs der Umlaufbahn der Förderkette 37 sind Umlenkräder vorgesehen, von denen eines mit dem Bezugszeichen 43 angedeutet ist. Im Bereich der Wellengeneratoren wird die Förderkette durch Schienen 45 geführt. In regelmässigen Abständen sind an den Gliedern 47 der Förderkette Bügel 49 befestigt, die als Träger für die zu behandelnden Substrate 51 dienen. Die Substrate 51 werden zusammen mit den zu verlötenden Bauteilen 53 zugeführt, die in an sich bekannter Weise mittels einer Lehre 55 mit Ausnehmungen 57, die an die Form der Bauteile angepasst sind, in der gewünschten Lage auf dem Substrat gehalten werden.

Zum Durchführen des erfindungsgemässen Verfahrens werden die Substrate 51 zusammen mit den Einzelteilen 53 und den Lehren 55 mit Hilfe von Führungs- und Klemmelementen 59 auf den Bügeln 49 befestigt. Die Substrate werden durch die Förderkette 37 derart an den aufeinanderfolgenden Wellengeneratoren 3, 5, 7 und 9 entlanggeführt, dass die Substrate 51 mit ihrer unbestückten Unterseite in Berührung gebracht werden mit den stehenden Wellen flüssigen Metalls W; hierbei wird ein Abheben und Verschieben der Substrate in einer Richtung quer zur Förderrichtung unter Einfluss der Wellen W verhindert durch die Führungs- und Klemmelemente 59, welche die Substrate 51 auf den Bügeln 49 festhalten und somit die Substrate gegen die Wellen W andrücken.

Die Wellengeneratoren 3 und 5 sind identisch und bilden zusammen eine Vorheizeinheit T1; der Wellengenerator 7 ist als Löteinheit T2 zum Erhitzen der Substrate auf Löttemperatur wirksam, während der Wellengenerator 9 als Kühleinheit T3 wirksam ist. Für einen optimalen Behandlungsvorgang müssen die einzelnen Einheiten Metallegierungen mit einem geeigneten Schmelzpunkt und mit verschiedenen Temperaturen enthalten. Die gewünschte Temperatur des Metalls in den Behältern 11 kann dadurch erhalten werden, dass ein Widerstandselement geeigneter Leistung gewählt wird. Die Leistung kann zur Einhaltung einer bestimmten Metalltemperatur geregelt werden.

Vorzugsweise wird eine Metallegierung gewählt, die zum Gebrauch in allen Einheiten geeignet ist. Insbesondere für die Löteinheit können jedoch andere Legierungen mit einem höheren Schmelzpunkt als dem der Legierungen der Vorheizeinheit und Kühleinheit gewählt werden.

Ein weiterer wichtiger Parameter ist die Kontaktzeit während der einzelnen Phasen. Bei konstanter Fördergeschwindigkeit der zu behandelnden Substrate kann die Kontaktzeit durch die Anzahl Wellengeneratoren je Einheit und/oder durch Bestimmung der effektiven Wellenlänge je Wellengenerator beeinflusst werden. In dem dargestellten Ausführungsbeispiel enthält die Vorheizeinheit T1 zwei Wellengeneratoren, wodurch die Kontaktzeit im Vergleich zu der Löteinheit T2 und der Kühleinheit T3 bereits verdoppelt wird. Weiterhin sind, wie aus der Zeichnung hervorgeht, die Ausströmöffnungen 19 der Wellengeneratoren 3 und 5 breiter als die Ausströmöffnungen 20 und 21 der Wellengeneratoren 7 und 9, wodurch eine grössere Länge der stehenden Wellen erzielt und die Kontaktzeit in der Vorheizphase weiter erhöht wird. Damit die Gesamtzykluszeit möglichst niedrig gehalten wird, werden die Wellengeneratoren möglichst dicht aneinander angeordnet.

Mit dem Verfahren und der Vorrichtung nach der Erfindung wurden auf Substraten aus Aluminiumoxyd mit einer Dicke von 0,7 mm Bauteile angelötet, deren maximal zulässige kritische Temperatur, bei der durch Überhitzung thermische Beschädigung der Einzelteile erfolgt, zwischen 85 °C und 114 °C schwankte. Die Substrate waren mit Palladium-Silber-Leiterspuren und örtlich mit einer 160 μm-dicken Lötpastenschicht aus einer Blei-Zinn-Legierung mit einem Schmelzpunkt von 183 °C versehen.

Der Lötvorgang wurde mit den folgenden Parameterwerten durchgeführt:
Vorschubgeschwindigkeit V:     3 cm/Sekunde
Vorheizeinheit T1:
    Anzahl Wellengeneratoren: 2;
    wirksame Wellenlänge je Wellengenerator: 12 cm;
    Metallegierung: Blei-Zinn-Wismut;
    Schmelzpunkt: zwischen 95 bis 110 °C;
    Temperatur: 180 ± 5 °C;
    Gesamtkontaktzeit: 8 Sekunden.
Löteinheit T2:
    Anzahl Wellengeneratoren: 1;
    Wirksame Wellenlänge: 6 cm;
    Metallegierung: Blei-Zinn-Wismut;

    Schmelzpunkt: zwischen 95 und 110 °C;
    Temperatur: 250 ± 3 °C;
    Kontaktzeit: 2 Sekunden.
Kühleinheit T3:
    Anzahl Wellengeneratoren: 1;
    Wirksame Wellenlänge: 6 cm;
    Metallegierung: Blei-Zinn-Wismut;
    Schmelzpunkt: zwischen 95 und 110 °C;
    Temperatur: 110 ± 5 °C;
    Kontaktzeit: 2 Sekunden.

Die Gesamtzykluszeit T betrug 14 Sekunden. Die erzielten Ergebnisse waren äusserst befriedigend. Die Lötverbindungen waren regelmässig, porenfrei und hatten ein sauberes Aussehen; die Zugfestigkeit entsprach weitgehend den gestellten Anforderungen. Eine Beschädigung der Bauteile und/oder der Substrate hat nicht stattgefunden; die Reproduzierbarkeit erwies sich als ausgezeichnet.

Das Verfahren und die Vorrichtung können auf ziemlich einfache Weise an verschiedenartige Substrate und/oder Bauteile durch Einstellung der Temperaturen, durch geeignete Wahl der Legierungen, durch Bestimmung der wirksamen Wellenlänge, durch Regelung der Fördergeschwindigkeit usw. angepasst werden.

**Patentansprüche**

1. Verfahren zum Anlöten von Bauteilen an ein Dickschichtsubstrat, das örtlich mit einer Schicht aus Lötpaste versehen ist, auf der dir Bauteile ruhen, wobei das Substrat in einer Vorheizphase auf eine Temperatur unterhalb des Schmelzpunktes des Lotes in der Lötpaste vorgeheizt wird, daraufhin in einer Lötphase derart erhitzt wird, dass das Lot geschmolzen und verflüssigt wird und schliesslich in einer Kühlphase auf eine Temperatur unterhalb des Schmelzpunktes abgekühlt wird, dadurch gekennzeichnet, dass das Substrat in jeder der drei Phasen mit erhitztem flüssigem Metall in Berührung gebracht wird, das als Wärmeübertragungsmedium wirksam ist.

2. Verfahren nach Anspruch 1, dadurch gekennzeichnet, dass das Substrat nacheinander an einer Anzahl stehender Wellen flüssigen Metalls entlanggeführt und gegen dieselben angedrückt wird.

3. Verfahren nach Anspruch 1 oder 2, dadurch gekennzeichnet, dass das Substrat in der Vorheizphase in zwei Schritten vorgeheizt wird.

4. Verfahren nach einem der vorstehenden Ansprüche, wobei ein Substrat aus Aluminiumoxyd mit Lötpaste versehen ist, die aus einer Blei-Zinn-Legierung mit einem Schmelzpunkt von 183 °C besteht, dadurch gekennzeichnet, dass in der Vorheizphase sowie in der Lötphase und der Kühlphase als flüssiges Metall jeweils eine Blei-Zinn-Wismut-Legierung verwendet wird mit einem Schmelzpunkt zwischen 95 und 110 °C und mit einer Temperatur von 180 ± 5C, 250 ± 3 °C bzw. 110 ± 5 °C, wobei das Substrat in der Vorheizphase während 8 Sekunden, in der Lötphase während 2 Sekunden und in der Kühlphase während 2 Sekunden mit dem flüssigen Metall in Berührung gebracht wird.

5. Dickschichtsubstrat mit Bauteilen, die mit Hilfe des Verfahrens nach einem der vorhergehenden Ansprüche mit dem Substrat verlötet sind.

6. Vorrichtung zum Durchführen des Verfahrens nach einem der Ansprüche 1 bis 4, mit einer Vorheizeinheit, einer Löteinheit und einer Kühleinheit, sowie mit Fördermitteln zum kontinuierlichen Transport von Substraten mit damit zu verlötenden Bauteilen an den genannten Einheiten entlang, wobei die Löteinheit einen Wellengenerator zum Erzeugen einer stehenden Welle heissen flüssigen Metalls aufweist, dadurch gekennzeichnet, dass die Vorheizeinheit und die Kühleinheit ebenfalls als Wellengeneratoren ausgebildet sind.

7. Vorrichtung nach Anspruch 6, dadurch gekennzeichnet, dass die Vorheizeinheit zwei Wellengeneratoren aufweist.

8. Vorrichtung nach Anspruch 6 oder 7, dadurch gekennzeichnet, dass die Fördermittel mit Führungs- und Klemmelementen versehen sind zum Festhalten der Substrate in Richtung quer zur Förderrichtung.

## Claims

1. A method of soldering components to a thick-film substrate which is locally provided with a layer of solder paste, on which the components rest, the substrate being preheated to a temperature below the melting point of the solder in the solder paste during a preheating phase, after which it is heated during a soldering phase so that the solder melts and liquefies, after which it is cooled to a temperature below the melting point during a cooling phase, characterized in that during each of the three phases the substrate is brought into contact with heated liquid metal which serves as a heat transfer medium.

2. A method as claimed in Claim 1, characterized in that the substrate is succesively guided along a number of standing waves of liquid metal and is pressed thereagainst.

3. A method as claimed in Claim 1 or Claim 2, characterized in that the substrate is preheated in two steps during the preheating phase.

4. A method as claimed in any preceding Claim, wherein a substrate of aluminium oxide is provided with a solder paste consisting of a lead-tin alloy having a melting point of 183°C, characterized in that during the preheating phase as well as during the soldering phase and the cooling phase use is made of a liquid metal in the form of a lead-tin-bismuth alloy with a melting point between 95 and 110°C, the temperature being 180 ± 5°C, 250 ± 3°C and 110 ± 5°C, respectively, the substrate being brought into contact with the liquid metal for 8 seconds during the preheating phase, for 2 seconds during the soldering phase, and for 2 seconds during the cooling phase.

5. A thick-film substrate with components soldered to the substrate by means of the method claimed in any preceding Claim.

6. An apparatus for performing the method claimed in any of Claims 1 to 4, comprising a preheating unit, a soldering unit and a cooling unit, and transport means for continuously transporting substrates with components to be soldered thereto along the said units, the soldering unit comprising a wave generator for generating a standing wave of hot liquid metal, characterized in that the preheating unit and the colling unit are also constructed as wave generators.

7. An apparatus as claimed in Claim 6, characterized in that the preheating unit comprises two wave generators.

8. An apparatus as claimed in Claim 6 or 7, characterized in that the transport means comprise guide and clamping members for retaining the substrates in a direction transverse to the transport direction.

## Revendications

1. Procédé pour souder des constituants sur un substrat en forme de couche épaisse muni localement d'une couche de pâte de soudure sur laquelle reposent les constituants, procédé suivant lequel, au cours d'une étape de préchauffage, le substrat et porté à une température inférieure au point de fusion de la soudure, alors qu'ensuite, au cours d'une étape de soudage, le substrat est chauffé de façon à donner lieu à la fusion et à la coulée de la soudure, après quoi finalement, au cours d'une étape de refroidissement, le substrat est refroidi jusqu'à une température inférieure au point de fusion de la soudure, caractérisé en ce que dans chacune des trois étapes le substrat est mis en contact avec du métal liquide chaud, le métal faisant office d'agent de transfert de chaleur.

2. Procédé selon la revendication 1, caractérisé en ce que le substrat est conduit successivement le long de plusieurs ondes stationnaires de métal liquide et est appliqué contre celles-ci.

3. Procédé selon la revendication 1 ou 2, caractérisé en ce que le préchauffage du substrat s'effectue en deux étapes.

4. Procédé selon l'une quelconque des revendications précédentes, le substrat en oxyde d'aluminium étant muni d'une pâte de soudure formée par un alliage plomb-étain à point de fusion de 183°C, caractérisé en ce que tant dans l'étape de préchauffage que dans les étapes de soudage est de refroidissement, on utilise comme métal liquide un alliage plomb-étain-bismuth dont le point de fusion est compris entre 95°C et 110°C, et qui a une température respectivement de 180°C ± 5°C, de 250°C ± 3°C et de 110°C ± 5°C, la durée de contact entre le substrat et l'alliage étant de huit secondes dans l'étape de préchauffage, de deux secondes dans l'étape de soudage, et de deux secondes dans l'étape de refroidissement.

5. Substrat en forme de couche épaisse et garni de constituants, qui ont été soudés sur ce substrat par la mise en œuvre du procédé selon l'une quelconque des revendications précédentes.

6. Dispositif permettant la mise en œuvre du procédé selon l'une quelconque des revendications 1 à 4 et comportant une unité de préchauffage, une unité de soudage, une unité de refroidissement ainsi que des moyens qui, le long de ces unités, doivent réaliser l'avance ininterrompue des substrats munis des constituants à souder sur ceux-ci, l'unité de soudage comportant un générateur d'onde pour engendrer une onde stationnaire de métal liquide chaud, caractérisé en ce que l'unité de préchauffage ainsi que l'unité de refroidissement sont également réalisées sous forme de générateur d'onde.

7. Dispositif selon la revendication 6, caractérisé en ce que l'unité de préchauffage comporte deux générateurs d'onde.

8. Dispositif selon la revendication 6 ou 7, caractérisé en ce que les moyens d'avance sont munis d'organes de guidage et de serrage pour maintenir les substrats dans une direction transversale à la direction d'avance.